# EUROPEAN PATENT SPECIFICATION

(11) **EP 0 366 220 B1**
(45) Date of publication and mention of the grant of the patent: **12.10.1994**
(21) Application number: 89302885.2
(22) Date of filing: 22.03.1989
(51) Int. Cl.: H05K 7/10

(54) **Positive retention chip carrier**
Chipträger mit positiver Haltevorrichtung
Support de composant avec montage de sûreté

(30) Priority: 27.10.1988 US 263370
(43) Date of publication of application: 02.05.1990
(73) Proprietor: PRECISION MONOLITHICS INC., Santa Clara California 95052 (US)
(72) Inventor: Morton William D. Jr., Santa Clara CA 95054 (US)
(74) Representative: Crawford, Andrew Birkby

(56) References cited:
- FR-A- 1 331 803
- US-A- 3 163 393
- US-A- 3 516 044

## Description

This invention relates to a carrier for retaining an integrated circuit (IC) chip in place during final manufacturing and testing of the chip. More particularly, it relates to a carrier for an IC chip having a cylindrical can body with a number of electrical leads projecting from the bottom of the can in a circular pattern.

Carrier devices are known for integrated circuit (IC) chip cans wherein the electrical leads projecting from the bottom of the can extend through D-shaped holes in the base of the carrier. These holes retain the leads in place. However, the use of such D-shaped holes results in bending or scraping of the soft solder electrical leads during manual or machine insertion and removal of the can from the carrier.

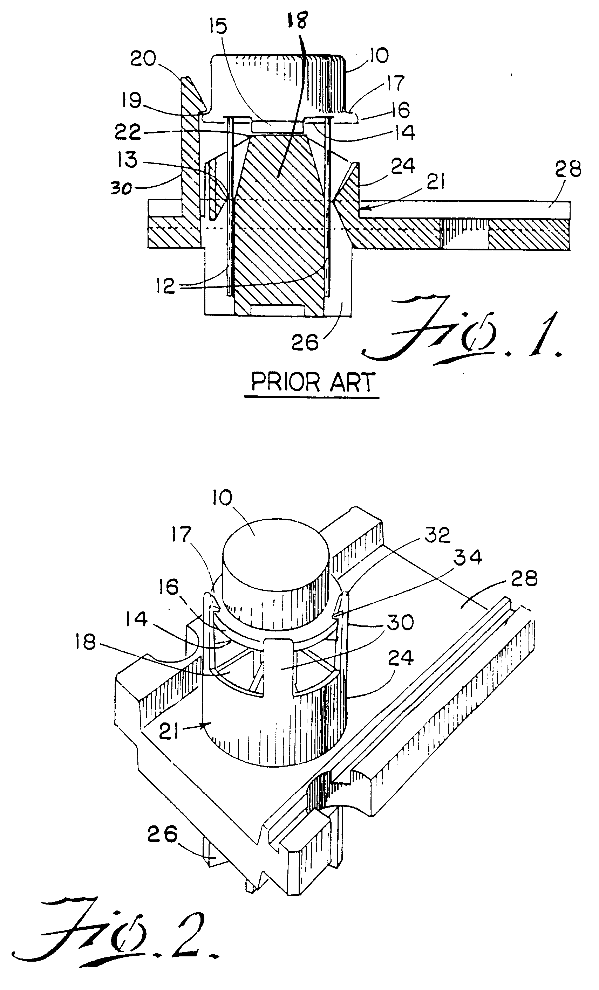

Other carrier devices are known in which a single arm extending from the carrier is snapped over a flange on the lower perimeter of the can to keep it in place. FIG. 1 is a cross-sectional view of a typical prior art carrier for a can-type IC chip having such a single arm. In FIG. 1 an IC can 10 has electrical leads 12 extending from its lower end 14, a stand-off 15 projecting from its lower end, and a flange 16 on the perimeter of lower end 14. Can 10 is retained in the carrier by a single flexible arm 30 having a hook 19 on its arm end 20 projecting therefrom that engages flange 16. Leads 12 are received by holes 13 in a tapered section 18 and in a base 21. A tapered first section 18 projects from base 21 and has a flat top end 22 upon which stand-off 15 of can 10 sits. Base 21 has an upper cylindrical base section 24 and a lower cylindrical base section 26. A platform 28 attached to base 21 at the junction of upper base section 24 and lower base section 26 is used to stabilize the carrier during manufacturing and testing procedures.

A major disadvantage with carriers like the one depicted in FIG. 1 is that single flexible arm 18 places an unbalanced load on can 10, causing the soft solder leads 12 to bend. Leads 12 normally are in a circular pattern that is concentric to the circumference of cylindrical can 10. Prior art devices bend these leads and thus disrupt this concentricity. After the can has been removed from the carrier, the leads typically must be laboriously, manually straightened to reestablish this concentricity before the can may be used in other operations.

A second disadvantage of such prior art devices like the one depicted in FIG. 1 is that flexible arm 18 extends too far above the upper surface 17 of flange 16 and thereby obscures a portion of the can body so that identifying information cannot be printed on the side of can 10 while it is in the carrier.

Other IC chip carriers are known for flat pack or DIP chips. In U.S. Patent No. 4,379,505 issued April 12, 1983 to Alemanni, and U.S. Patent No. 4,591,053 issued May 27, 1986 to Alemanni, four resilient retaining fingers are used to retain the flat pack by contacting its outermost leads. The disadvantage of this approach is that it may bend or otherwise harm the soft leads.

U.S. Patent No. 3,746,157 issued July 17, 1973 to L'Anson discloses a carrier for retaining a flat pack using a snap-in retaining clip, the underside of which is plated with a conductor material such as aluminum. When the retaining clip is in place, this undersurface bridges the conductors of the flat pack, shorting them to one and other. Of course, this approach is not suitable for operations where the leads should not be shorted.

Other carriers are known for retaining flat packs and DIPs. See U.S. Patent No. 4,556,145 issued December 3, 1985 to Putnam; U.S. Patent No. 3,892,312 issued July 1, 1975 to Tems; and U.S. Patent No. 3,652,974 issued March 28, 1972 also to Tems. However, none of these carriers is suitable for retaining a can-type body.

United States patent US-A-3,516,044 discloses a carrier for a transistor outline semiconductor device with a carrier base structure supporting funnel-like lead entrances adjacent the several openings extending through the base structure, in such a way that the device may be manipulated and operated upon by standard equipment for handling integrated circuit devices.

United States patent US-A-3,163,393 discloses a component holder means mountable upon a mounting board and comprising:
receptacle means having a cylindrically shaped side wall and closed at one end and open at the other end;
said cylindrically shaped side wall of said receptacle means comprised of arcuate segments separated one from the other by slots cut through said cylindrically shaped side wall and running axially along the length of said side wall and extending through the closed end of said receptacle means;
the outside surface of said closed end of said receptacle means being generally concave in shape; and
fastening means extending outwardly from said closed end and substantially along the axis of said receptacle means and constructed to secure said component holder means to said mounting board.

It is a feature of the present invention to provided an IC chip carrier for a cylindrical can that eliminates the scraping of the soft solder leads of the chip during insertion and removal of the chip from the carrier.

It is another feature of the present invention to provide an IC chip carrier for a can that eliminates the bending of the soft solder electrical leads of the chip while the chip is retained in the carrier and retains the concentricity of the circular lead pattern with the circumference of the can.

It is yet another feature of the present invention to provide an IC chip carrier which allows information to be printed on the side of the can while it is retained in the carrier.

It is yet another feature of the present invention to provide an IC chip carrier that securely retains the chip during manufacturing and testing operations.

According to the present invention there is provided a carrier for an integrated circuit (IC) can, said can having a lower end, a plurality of electrical leads extending from the lower end, a stand-off projecting from the lower end, a flange around the perimeter of the lower end, said flange having an upper surface, and a surrounding wall extending upward from the flange, the carrier comprising:
a base having a plurality of openings to receive said plurality of leads;
a support section projecting from the base. the support section having a top end for supporting the stand-off to limit the inward position of a can when it is inserted into the carrier, and a plurality of openings to receive said plurality of leads; and
at least three flexible arms projecting from the base and arranged in a symmetrical configuration around the support section to flex in opposition to each other and to retain an IC can inserted therebetween;
wherein the arms are for releasably retaining an IC can by virtue of the end of each arm having an inward projection with a lower surface which is arranged to abut against the upper flange surface of an IC can when inserted between the arms to prevent upward movement of the can, said projections extending inwardly from their respective arms by about 0.12 - 0.25mm (0.005 - 0.010 inch), said projections being tapered so that said arms terminate not more than 0.08mm (0.003 inch) above said lower projection surfaces, whereby substantially the entire surface of said surrounding wall is exposed for printing and said arms avoid substantial obstruction to the placement of printed information on said surrounding wall while the can is retained in the carrier, said projections bearing against the flange of an IC can when the can is inserted between or removed from said arms to flex said arms backward to permit the IC can to be admitted or released.

These and other features and advantages of the invention will be apparent to those skilled in the art from the following detailed description of preferred embodiments, taken together with the accompanying drawings, in which:

FIG. 1 is a cross-section of a typical prior art carrier for an IC can-type chip.

FIG. 2 is a perspective view of a carrier according to the present invention.

FIG. 3 is a top view of a carrier according to the present invention.

FIG. 4 is a cross-section of the carrier depicted in FIG. 3, taken along line 4-4.

FIG. 5 is an exploded view of the flexible arm according to the present invention.

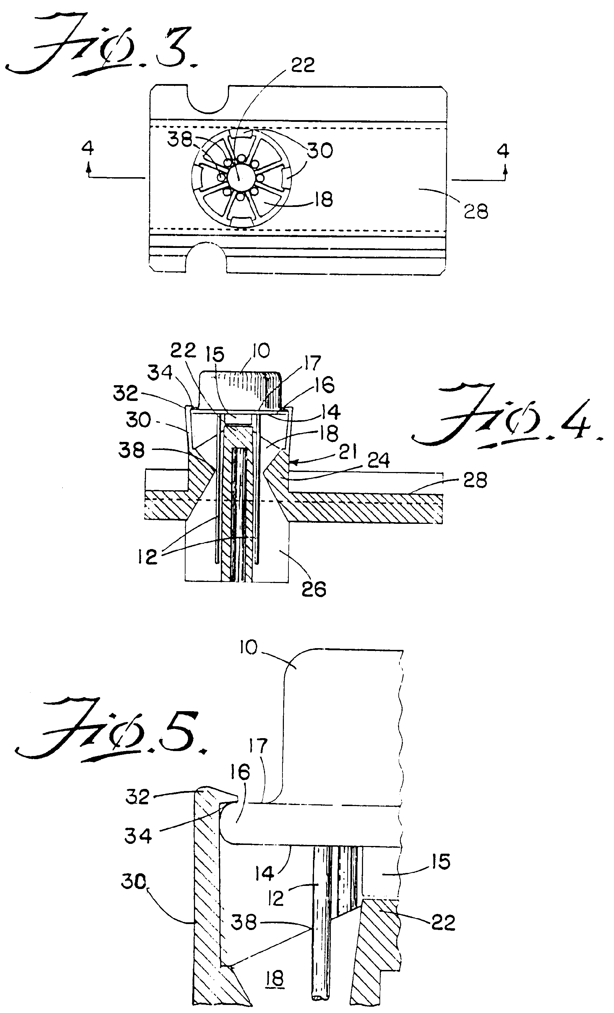

FIG. 2 is a perspective view of an integrated chip (IC) carrier according to the present invention. In FIG. 2, an IC can 10 has electrical leads 12 extending from its lower end 14 in a circular arrangement that is concentric with the circumference of cylindrical can 10. Can 10 also has a flange 16 on the circumference or perimeter of its lower end 14. Can 10 is retained in the carrier by a plurality of flexible arms 30, each of which has an arm end 32 and a hook 34 projecting from arm end 32 for engaging flange 16. Hook 34 engages flange 16 to retain the can in the carrier.

Flexible arms 30 are symmetrically arranged around the circumference of can 10 to impart an even load upon can 10 when the can is retained in the carrier. Three or more arms 30 may be used to engage flange 16, as long as they are symmetrically distributed around the circumference of the can. This symmetrical distribution of the forces imparted on the can by arms 30 minimizes the bending of electrical leads 12 while the can is in the carrier. The concentricity between the circular lead pattern and the outer circumference of the can is thereby retained, obviating the laborious manual process of straightening the bent leads after the can is removed from a prior art IC chip carrier that imparts an uneven load upon the can, like the carrier depicted in FIG. 1.

Referring again to FIG. 2, leads 12 are received by holes 38 (not shown) in a tapered first section 18 and in a base 21. Tapered section 18 projects from base 21 and has a flat top end 22 (not shown) upon which rests a stand-off 15 (not shown) attached to lower end 14 of can 10. Base 21 has an upper cylindrical base section 24 and a lower cylindrical base section 26. A flat platform 28 attached to base 21 at the junction of upper base section 24 and lower base section 26 is used to stabilize the carrier during manufacturing and testing procedures.

FIG. 3 depicts a top view of an IC chip carrier according to the present invention. In FIG. 3 four arms 30 project from the base and are symmetrically arranged to impart an even load upon the can (not shown). For a typical IC can held in place by 4 arms, the opposing arms 30 are about 8.89 - 9.14mm (0.350 - 0.360 inches) apart, with 9.14mm (0.360 inches) being a preferred distance. Tapered first section 18 has a flat top end 22. Tapered section 18 has a plurality of round holes 38 distributed in a circular pattern for receiving the electrical leads projecting from the lower end of the can. Holes 38 are round, unlike the D-shaped holes in prior art devices, to minimize the bending and scraping of the soft solder leads during insertion and removal of the can from the carrier.

FIG. 4 is a cross-sectional view of the carrier depicted in FIG. 3, taken along line 4-4. In FIG. 4, electrical leads 12 projecting from the lower end 14 of can 10 are received by a plurality of holes 38 in tapered first section 18, upper cylindrical base section 24, and lower cylindrical base section 26. Stand-off 15 projecting from the lower end 14 of can 10 sits upon the flat top end 22 of tapered section 18 when can 10 is retained in the carrier. First section 18 may be of a variety of shapes, including a cone or a pyramid.

FIG. 4 depicts another important feature of the present invention, namely that arms 30 are designed to have a low profile so that their arm ends 32 do not extend substantially above upper surface 17 of flange 16. In a preferred embodiment, arm end 32 extends between 0.08 and 0.53mm (0.003 - 0.021 inches) above the upper surface of flange 16, with 0.08mm (0.003 inches) being the preferred distance. The amount of this extension depends upon the height of stand-off 15, which varies between about 0.43 - 0.89mm (0.017 - 0.035 inches) from can to can. The purpose of this low profile is to permit information to be printed on the side of a can while the can is retained in the carrier. The high profile of arm end 20 in the prior art device depicted in FIG. 1 prevents information from being printed on the side of the can while the can is in the carrier.

The shape of flexible arms 30 is more clearly shown in the exploded view depicted in FIG. 5. In FIG. 5 a flexible arm 30 engages flange 16 of can 10 by means of arm end 32 having a hook 34 projecting therefrom. Hook 34 may have a variety of shapes as long as it has a low profile as discussed above. In a preferred embodiment, hook 34 has the shape of an isosceles triangle, with the angle of the vertex farthest away from arm end 32 being about 30°. Hook 34 projects from arm end 32 between 0.12 - 0.25mm (0.005 - 0.010 inches). The preferred length of the projection is 0.12mm (0.005 inches). FIG. 5 also depicts the low profile design of arm 38 as discussed in connection with FIG. 4 above.

While particular embodiments of the invention have been shown and described, numerous modifications and alternate embodiments will occur to those skilled in the art. Accordingly, it is intended that the invention be limited only by the following claims.

## Claims

1. A carrier for an integrated circuit (IC) can (10), said can having a lower end (14), a plurality of electrical leads (12) extending from the lower end (14), a stand-off (15) projecting from the lower end (14), a flange (16) around the perimeter of the lower end (14), said flange having an upper surface (17), and a surrounding wall extending upward from the flange, the carrier comprising:
a base (21) having a plurality of openings (38) to receive said plurality of leads (12);
a support section (18) projecting from the base (21), the support section having a top end (22) for supporting the stand-off (15) to limit the inward position of a can when it is inserted into the carrier, and a plurality of openings (38) to receive said plurality of leads (12);
characterised by
at least three flexible arms (30) projecting from the base (21) and arranged in a symmetrical configuration around the support section (18) to flex in opposition to each other and to retain an IC can (10) inserted therebetween;
wherein the arms are for releasably retaining an IC can by virtue of the end (32) of each arm (30) having an inward projection (34) with a lower surface which is arranged to abut against the upper flange surface of an IC can when inserted between the arms (30) to prevent upward movement of the can, said projections (34) extending inwardly from their respective arms (30) by about 0.12 - 0.25mm (0.005 - 0.010 inch), said projections (34) being tapered so that said arms (30) terminate not more than 0.08mm (0.003 inch) above said lower projection surfaces, whereby substantially the entire surface of said surrounding wall is exposed for printing and said arms (30) avoid substantial obstruction to the placement of printed information on said surrounding wall while the can is retained in the carrier, said projections (34) bearing against the flange (16) of an IC can when the can is inserted between or removed from said arms to flex said arms backward to permit the IC can to be admitted or released.

2. The carrier of claim 1, wherein said holes (38) are arranged in said base (21) and in said support section (18) in matching substantially circular patterns.

3. The carrier of claims 1 or 2, wherein said holes (38) are substantially round.

4. The carrier of claims 1, 2 or 3, wherein said support section (18) is substantially conical in shape.

5. The carrier of claim 1, 2 or 3, wherein said support section (18) is a pyramid.

6. The carrier of any of the preceding claims, wherein said base (21) is substantially cylindrical.

7. The carrier of any of the preceding claims, further comprising:
a platform (28) connected to the base (21) and projecting therefrom.

8. The carrier of any of the preceding claims, wherein said arms (30) and the portion of the base (21) from which they extend conform to a cylinder when retaining an IC can (10).

9. The carrier of claim 8, wherein the width of each of said arms (30) is such that the total width of all arms occupies a minor portion of the circumference of said cylinder.

10. The carrier of any of the preceding claims, wherein said arms (30) have uniform thicknesses below said projections (34).

11. The carrier of any of the preceding claims, wherein both the upper and lower surfaces of said projections (34) are tapered.

## Patentansprüche

1. Träger für einen Becher (10) mit einem integrierten Schaltkreis (IC), wobei der Becher ein unteres Ende (14) aufweist, eine Vielzahl von elektrischen Leitern (12), die sich von dem unteren Ende (14) aus erstrekken, einen Abstandsisolator (15), der von dem unteren Ende (14) vorsteht, einen Flansch (16) um den Umfang des unteren Endes (14) herum, wobei der Flansch eine Oberseite (17) aufweist, sowie eine umgebende Wand, die sich oberhalb von dem Flansch erstreckt, wobei der Träger umfaßt:
eine Basis (21) mit einer Vielzahl von Öffnungen (38) zur Aufnahme der Vielzahl von Leitern (12);
einen Trageabschnitt (18), der von der Basis (21) vorsteht, wobei der Trageabschnitt ein oberes Ende (22) hat, das den Abstandsisolator (15) trägt, um die innere Stellung eines Bechers zu begrenzen, wenn er in den Träger eingeführt wird, sowie eine Vielzahl von Öffnungen (38) zur Aufnahme der Vielzahl von Leitern (12);
**gekennzeichnet durch**
wenigstens drei flexible Arme (30), die von der Basis (21) vorstehen und in einer symmetrischen Form um den Trageabschnitt (18) herum angeordnet sind, so daß sie sich aufeinander zu biegen und so einen zwischen sie eingeführten IC-Becher (10) halten;
wobei die Arme dazu dienen, einen IC-Becher dadurch zu halten, daß das Ende (32) jedes Arms (30) einen nach innen gerichteten Vorsprung (34) mit einer Unterseite hat, die an der oberen Flanschseite eines IC-Bechers anliegt, wenn er zwischen die Arme (30) eingeführt wird, um nach oben gerichtete Bewegung des Bechers zu verhindern, wobei sich die Vorsprünge (34) von ihren entsprechenden Armen (30) um ungefähr 0,12 - 0,25 mm (0,005 - 0,010 Inch) nach innen erstrecken, wobei die Vorsprünge (34) konisch sind, so daß die Arme nicht mehr als 0,08 mm (0,003 Inch) oberhalb der unteren Seiten der Vorsprünge enden, wodurch im wesentlichen die gesamte Fläche der umgebenden Wand zum Bedrucken freiliegt, und die Arme (30) wesentliche Behinderung der Aufbringung gedruckter Informationen auf der umgebenden Wand verhindern, wenn der Becher in dem Träger gehalten wird, wobei die Vorsprünge (34) an dem Flansch (16) eines IC-Bechers anliegen, wenn der Becher zwischen die Arme eingeführt oder aus ihnen entfernt wird, wodurch die Arme zurückgebogen werden, um Einführung oder Entnahme des IC-Bechers zu ermöglichen.

2. Träger nach Anspruch 1, wobei die Löcher (38) in der Basis (21) und dem Trageabschnitt (18) in gleichen, im wesentlichen kreisförmigen Strukturen angeordnet sind.

3. Träger nach Anspruch 1 oder 2, wobei die Löcher (38) im wesentlichen rund sind.

4. Träger nach Anspruch 1, 2 oder 3, wobei der Trageabschnitt (18) im wesentlichen konische Form hat.

5. Träger nach Anspruch 1, 2 oder 3, wobei der Trageabschnitt (18) eine Pyramide ist.

6. Träger nach einem der vorangehenden Ansprüche, wobei die Basis (21) im wesentlichen zylindrisch ist.

7. Träger nach einem der vorangehenden Ansprüche, der des weiteren umfaßt:
eine Plattform (28), die mit der Basis (21) verbunden ist und von selbiger vorsteht.

8. Träger nach einem der vorangehenden Ansprüche, wobei die Arme (30) und der Teil der Basis (21), von dem aus sie sich erstrecken, einem Zylinder entsprechen, wenn sie einen IC-Becher (10) halten.

9. Träger nach Anspruch 8, wobei jeder der Arme (30) eine solche Breite hat, daß die Gesamtbreite aller Arme einen geringfügigen Teil des Umfangs des Zylinders einnimmt.

10. Träger nach einem der vorangehenden Ansprüche, wobei die Arme (30) unterhalb der Vorsprünge (34) gleichmäßig dick sind.

11. Träger nach einem der vorangehenden Ansprüche, wobei sowohl die Ober- als auch die Unterseiten der Vorsprünge (34) konisch sind.

## Revendications

1. Support pour un boîtier (10) de circuit intégré (IC), ledit boîtier ayant une extrémité inférieure (14), une pluralité de fils électriques (12) s'étendant depuis l'extrémité inférieure (14), une saillie (15) qui se projette depuis l'extrémité inférieure (14), une bride (16) autour du périmètre de l'extrémité inférieure (14), ladite bride présentant une surface supérieure (17), et une paroi périphérique qui s'étend vers le haut depuis la bride, le support comprenant :
- une base (21) ayant une pluralité d'ouvertures (38) afin de recevoir ladite pluralité de fils (12) ;
- une section de support (18) qui se projette depuis la base (21), la section de support ayant une extrémité supérieure (22) afin de supporter la saillie (15) pour limiter la position d'un boîtier vers l'intérieur lorsqu'il est introduit dans le support, et une pluralité d'ouvertures (38) pour recevoir ladite pluralité de fils (12) ;
caractérisé en ce que
- il est prévu au moins trois bras flexibles (30) qui se projettent depuis la base (21) et sont agencés suivant une configuration symétrique autour de la section de support (18) de manière à fléchir en opposition les uns par rapport aux autres et à retenir un boîtier (10) de circuit intégré introduit entre eux ;
- les bras sont destinés à retenir de façon libérable un boîtier de circuit intégré grâce au fait que l'extrémité (32) de chaque bras (30) possède une projection intérieure (34) avec une surface inférieure agencée de manière à venir en butée contre la surface supérieure de la bride d'un boîtier à circuit intégré lorsque celui-ci est introduit entre les bras (30) afin d'empêcher un mouvement montant du boîtier, lesdites projections (34) s'étendant vers l'intérieur depuis leurs bras respectifs (30) sur environ 0,12 à 0,25 mm (0,005 à 0,010 pouce), lesdites projections (34) étant inclinées de telle manière que lesdits bras (30) se terminent à une distance qui n'est pas supérieure à 0,08 mm (0,003 pouce) au-dessus desdites surfaces inférieures de la projection, grâce à quoi sensiblement la totalité de la surface de ladite paroi périphérique est exposée de manière à être imprimée, et lesdits bras (30) évitent une obstruction sensible vis-à-vis de l'apposition d'informations imprimées sur ladite paroi périphérique tandis que le boîtier est retenu dans le support, lesdites projections (34) portant contre la bride (16) d'un boîtier à circuit intégré lorsque le boîtier est introduit entre lesdits bras ou enlevé par rapport à ceux-ci, afin de faire fléchir lesdits bras en recul pour permettre d'admettre ou de relâcher le boîtier de circuit intégré.

2. Support selon la revendication 1, dans lequel lesdits trous (38) sont agencés dans ladite base (21) et dans ladite section de support (18) suivant des motifs circulaires sensiblement appariés.

3. Support selon l'une ou l'autre des revendications 1 et 2, dans lequel lesdits trous (38) sont sensiblement arrondis.

4. Support selon l'une quelconque des revendications 1 à 3, dans lequel ladite section de support (18) a une forme sensiblement conique.

5. Support selon l'une quelconque des revendications 1 à 3, dans lequel ladite section de support (18) est une pyramide.

6. Support selon l'une quelconque des revendications précédentes, dans lequel ladite base (21) est sensiblement cylindrique.

7. Support selon l'une quelconque des revendications précédentes, comprenant en outre une plate-forme (28) raccordée à la base (21) et se projetant depuis celle-ci.

8. Support selon l'une quelconque des revendications précédentes, dans lesdits bras (30) et la partie de la base (21) depuis laquelle ils s'étendent prennent la forme d'un cylindre lorsqu'ils retiennent un boîtier de circuit intégré (10).

9. Support selon la revendication 8, dans lequel la largeur de chacun desdits bras (30) est telle que la largeur totale de tous les bras occupe une mineure partie de la circonférence dudit cylindre.

10. Support selon l'une quelconque des revendications précédentes, dans lequel lesdits bras (30) ont des épaisseurs uniformes au-dessous desdites projections (34).

11. Support selon l'une quelconque des revendications précédentes, dans lequel les surfaces supérieure et inférieure desdites projections (34) sont toutes deux inclinées.
